# EUROPEAN PATENT SPECIFICATION

(11) **EP 2 254 169 B1**
(45) Date of publication and mention of the grant of the patent: **08.04.2015**
(21) Application number: 10162283.5
(22) Date of filing: 07.05.2010
(51) Int. Cl.: H01L 35/30, H01L 35/32

(54) **Thermoelectric device using radiant heat as heat source and method of fabricating the same**
Thermoelektrische Vorrichtung mit Strahlungswärme als Wärmequelle und Herstellungsverfahren dafür
Dispositif thermoélectrique utilisant un chauffage par rayonnement en tant que source de chaleur et son procédé de fabrication

(30) Priority: 21.05.2009 KR 20090044632; 25.02.2010 KR 20100016905
(43) Date of publication of application: 24.11.2010
(73) Proprietor: Electronics and Telecommunications Research Institute, Daejeon 305-700 (KR)
(72) Inventor: Park, Young Sam, 302-747, Daejeon (KR); Lim, Jung Wook, 305-330, Daejeon (KR); Jang, Moon Gyu, 305-330, Daejeion (KR)
(74) Representative: Betten & Resch

(56) References cited:
- EP-A1- 1 719 988
- MASAKI HIROTA: "Infrared sensor with precisely patterned Au black absorption layer", PROCEEDINGS OF SPIE, vol. 3436, 1 January 1998 (1998-01-01), pages 623-634, XP55028126, ISSN: 0277-786X, DOI: 10.1117/12.328062

## Description

### CROSS-REFERENCE TO RELATED APPLICATION

This application claims priority to and the benefit of Korean Patent Application Nos. 10-2009-0044632, filed May 21, 2009 and 10-2010-0016905, filed February 25, 2010.

### BACKGROUND

### 1. Field of the Invention

The present invention relates to a thermoelectric device using radiant heat as a heat source and a method of fabricating the same, and more particularly to a thermoelectric device that uses radiant heat as a heat source and can maximize the heat absorption efficiency of a heat absorption layer and the heat dissipation efficiency of a heat dissipation layer and a method of fabricating the same.

### 2. Discussion of Related Art

Due to increases in population and industrial development, the human race has been confronted with problems of energy shortage and environmental pollution.

To solve these problems, many scientists are conducting research on finding new energy sources to replace existing fossil fuels.

As a result of such research, a thermoelectric device that can convert radiant heat, such as solar heat, subterranean heat, body heat, waste heat, etc., into electrical energy has been developed.

MASAKI HIROTA: "Infrared sensor with precisely patterned Au black absorption layer", PROCEEDINGS OF SPIE, vol. 3436, 1 January 1998 (1998-01-01), pages 623-634, XP055028126, ISSN: 0277-786X, DOI: 10.1117/12.328062, describes an infrared sensor.

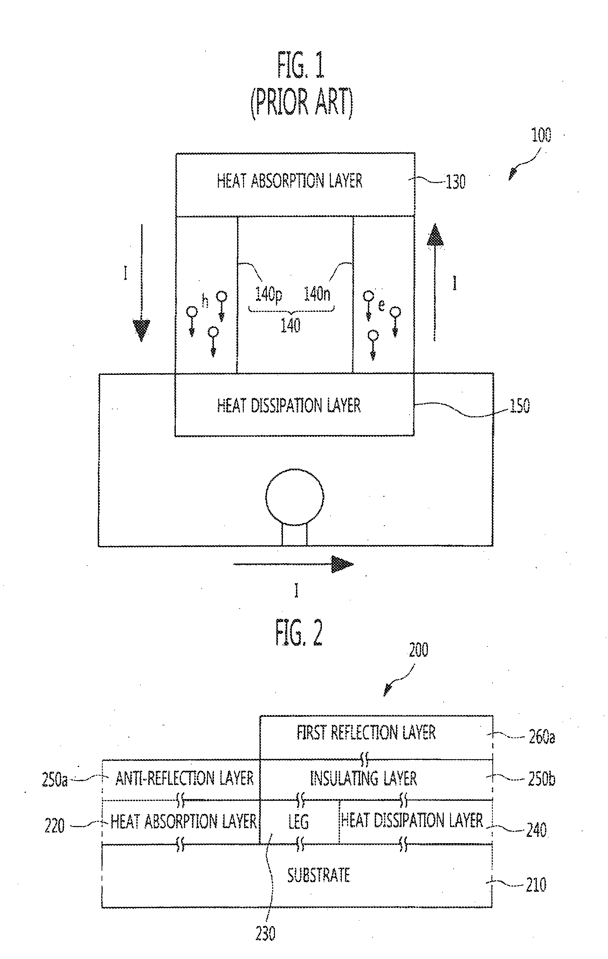

FIG. 1 is a block diagram of a conventional thermoelectric device.

Referring to FIG 1, a thermoelectric device 100 includes a heat absorption layer 130, a leg 140, and a heat dissipation layer 150, and the leg 140 consists of a p-type leg 140p and an n-typc leg 140n.

The heat absorption layer 130 absorbs external heat, the leg 140 transfers the heat absorbed by the heat absorption layer 130 to the heat dissipation layer 150, and the heat dissipation layer 150 dissipates the heat transferred from the leg 140 away from the heat dissipation layer 150.

Due to temperature difference between the heat absorption layer 130 and the heat dissipation layer 150, holes move from the heat absorption layer 130 toward the heat dissipation layer 150 in the p-type leg 140p, and electrons move from the heat absorption layer 130 toward to heat dissipation layer 150 in the n-type leg 140n. According to the movement of the holes and electrons, current flows counterclockwise.

To increase the thermoelectric efficiency of the thermoelectric device 100, the heat absorption layer 130 must absorb as much external heat as possible and transfer all the absorbed heat to the leg 140, and the leg 140 must transfer the heat transferred from the heat absorption layer 130 to the heat dissipation layer 150 as slowly as possible. And, the heat dissipation layer 150 must not absorb external heat at all but must dissipate the heat transferred from the leg 140 as much as possible.

In other words, the temperature difference between the heat absorption layer 130 and the heat dissipation layer 150 must be large for a high thermoelectric efficiency to be obtained.

As an indicator of a figure of merit, that is, thermoelectric efficiency of a thermoelectric device, a ZT value is used. The ZT value is proportional to the square of a Seebeck coefficient and electric conductivity, and is inversely proportional to thermal conductivity.

However, a thermoelectric device formed of metal has a very low Seebeck coefficient of several µV/K, and cannot have a high ZT value because electric conductivity is proportional to thermal conductivity according to the Wiedemann-Franz law.

To solve these problems, a thermoelectric device formed of a semiconductor is being developed. A typical thermoelectric device material may be Bi₂Te₃, which has a minimum ZT value of 0.7 at room temperature and a maximum ZT value of 0.9 at 120 °C, and SiGe, which has a minimum ZT value of 0.1 at room temperature and a maximum ZT value of 0.9 at 900 °C.

However, according to the late tendency of development and mass production of products employing thermoelectric devices, supplies of Bi₂Te₃ are predicted to become exhausted soon, For this reason, research on a material that can replace Bi₂Te₃, that is, a material having a minimum ZT value of 0.7 at room temperature is ongoing.

In this aspect, silicon has a very high thermal conductivity of about 150 W/mK and a ZT value of about 0.01, and thus has been considered difficult to use in thermoelectric devices. However, it has been lately reported that silicon nanowires grown by chemical vapor deposition (CVD) can reduce the thermal conductivity by 0.01 times or less and have a ZT value of almost 1. Thus, silicon nanowires are expected to be used in thermoelectric devices.

However, difficulty and complexity in fabricating silicon nanowires hinder mass production in an actual production step.

Meanwhile, solar heat is the most ideal heat source, since supply thereof is constant as long as the sun exists, and it causes no environmental pollution. Thus, if a high-efficiency thermoelectric device using radiant heat such as solar heat as a heat source is developed, it is expected to cause explosive demand due to marketability and applicability. However, research into a thermoelectric device using radiant heat such as solar heat as a heat source is still in its initial stages.

### SUMMARY OF THE INVENTION

The present invention is directed to implementing a high-efficiency thermoelectric device that uses radiant heat as a heat source, and can maximize the heat absorption efficiency of a heat absorption layer and the heat dissipation efficiency of a heat dissipation layer.

One aspect of the present invention provides a thermoelectric device using radiant heat as a heat source including: a substrate; a heat absorption layer formed on the substrate and absorbing radiant heat; a leg for transferring the heat absorbed by the heat absorption layer to a heat dissipation layer; the heat dissipation layer for dissipating the heat transferred from the leg away from the heat dissipation layer; an anti-reflection layer formed on the heat absorption layer and having a lower refractive index than the heat absorption layer; an insulating layer formed on the leg and the heat dissipation layer and having a lower refractive index than a first reflection layer; and the first reflection layer formed on the insulating layer and totally reflecting the radiant tight. Here, the radiant light is not reflected to the outside due to the anti-reflection layer but is absorbed by the heat absorption layer, and the radiant light is not absorbed by the heat dissipation layer but is totally reflected by the insulating layer and the first reflection layer.

Another aspect of the present invention provides a method of fabricating a thermoelectric device using radiant heat as a heat source, the method including: forming, on a substrate, a heat absorption layer absorbing radiant heat, a leg transferring the heat absorbed by the heat absorption layer to a heat dissipation layer, and the heat dissipation layer dissipating the heat transferred from the leg away from the heat dissipation layer; forming an anti-reflection layer having a lower refractive index than the heat absorption layer on the heat absorption layer, and an insulating layer having a lower refractive index than a first reflection layer to be formed later on the heat dissipation layer; and forming the first reflection layer totally reflecting radiant light on the insulating layer.

### BRIEF DESCRIPTION OF THE DRAWINGS

The above and other objects, features and advantages of the present invention will become more apparent to those of ordinary skill in the art by describing in detail exemplary embodiments thereof with reference to the attached drawings, in which:

FIG. 1 is a block diagram of a conventional thermoelectric device;

FIG. 2 is a cross-sectional block diagram of a thermoelectric device according to a first exemplary embodiment of the present invention;

FIG. 3 is a cross-sectional block diagram of a thermoelectric device according to a second exemplary embodiment of the present invention;

FIG. 4 is a cross-sectional block diagram of a thermoelectric device according to a third exemplary embodiment of the present invention; and

FIGS. 5A to 5E are cross-sectional block diagrams illustrating a method of fabricating a thermoelectric device according to an exemplary embodiment of the present invention.

### DETAILED DESCRIPTION OF EXEMPLARY EMBODIMENTS

Hereinafter, exemplary embodiments of the present invention will be described in detail. However, the present invention is not limited to the embodiments disclosed below but can be implemented in various forms. The following embodiments are described in order to enable those of ordinary skill in the art to embody and practice the present invention. Throughout this specification, when an element is referred to as "comprises," "includes," or "has" a component, it does not preclude another component but may further include the other component unless the context clearly indicates otherwise, In the drawings, the thickness of layers and regions may be exaggerated for clarity. When a layer is referred to as being "on" another layer or a substrate, it can be directly formed on the other layer or the substrate or an intervening layer may be present.

<First exemplary embodiment>

FIG. 2 is a cross-sectional block diagram of a thermoelectric device according to a first exemplary embodiment of the present invention.

Referring to FIG. 2, a thermoelectric device 200 according to the first exemplary embodiment of the present invention includes a heat absorption layer 220, a leg 230, and a heat dissipation layer 240 formed on a substrate 210, an anti-reflection layer 250a formed on the heat absorption layer 220, an insulating layer 250b formed on the leg 230 and the heat dissipation layer 240, and a first reflection layer 260a formed on the insulating layer 250b.

As the substrate 210, one of a silicon substrate, a glass substrate, a plastic substrate, a metal substrate, a silicon on insulator (SOI) substrate, and a multi-layer substrate in which these substrates are combined may be used.

The heat absorption layer 220 absorbs radiant heat such as solar heat, the leg 230 transfers the heat absorbed by the heat absorption layer 220 to the heat dissipation layer 240, and the heat dissipation layer 240 dissipates the heat transferred from the leg 230 away from the heat dissipation layer 240.

Here, the heat absorption layer 220 and the heat dissipation layer 240 may include at least one of group IV elements of the periodic table, Si, Ge, C, Sn and Pb, at least one of group V elements of the periodic table, Sb, As, Bi, P and N, or at least one of group VI elements of the periodic table, Te, Se, Po, S and O, and have a thickness of 10 nm to 1 cm.

The anti-reflection layer 250a causes external radiant light not to be reflected but to be absorbed by the heat absorption layer 220, which will be described in detail below.

The anti-reflection layer 250a is formed of a single dielectric layer or multiple dielectric layers having a lower refractive index than the heat absorption layer 220.

When external radiant light is incident on the anti-reflection layer 250a, it is not reflected at the interface between the anti-reflection layer 250a and the heat absorption layer 220 but is mostly transferred to the heat absorption layer 220 because the heat absorption layer 220 has a higher refractive index than the anti-reflection layer 250a. Thus, it is possible to increase the radiant heat absorption efficiency of the heat absorption layer 220.

In particular, when the refractive index of the anti-reflection layer 250a is adjusted to have a reflectance of 0 to 0.5 at a wavelength of radiant light to be absorbed, reflection of the radiant light is minimized so that the radiant heat absorption efficiency of the heat absorption layer 220 can be maximized.

When the anti-reflection layer 250a is formed of multiple dielectric layers, a dielectric layer having the lowest refractive index among the multiple dielectric layers may be formed in the uppermost layer, and dielectric layers may be formed in lower layers in order of increasing refractive indices. Then, it is possible to further increase the radiant heat absorption efficiency. Here, the refractive indices of all the dielectric layers must be lower than the refractive index of the heat absorption layer 220.

Meanwhile, the insulating layer 250b causes total reflection of the first reflection layer 260a while electrically and thermally insulating the heat dissipation layer 240 from external radiant heat, which will be described in detail below.

The insulating layer 250b is formed of a single dielectric layer or multiple dielectric layers having a lower refractive index than the first reflection layer 260a.

When external radiant light is incident on the first reflection layer 260a, it is totally reflected at the interface between the first reflection layer 260a and the insulating layer 250b because the first reflection layer 260a has a higher refractive index than the insulating layer 250b, Thus, it is possible to prevent the radiant heat from being absorbed by the heat dissipation layer 240.

Also, when the insulating layer 250b is formed of multiple dielectric layers, a dielectric layer having the lowest refractive index among the multiple dielectric layers may be formed in the uppermost layer, which is in contact with the first reflection layer 260a, and dielectric layers may be formed in lower layers in order of increasing refractive indices. Then, it is possible to further increase the radiant light reflection efficiency. Here, the refractive indices of all the dielectric layers must be lower than the refractive index of the first reflection layer 260a.

The first reflection layer 260a is formed of at least one of Al, Cu, Ti, Ag, Au, W, Si, Pt, Ni, Mo, Ta, Ir, Ru, Zn, Sn and In, and totally reflects external radiant light.

Thus, the thermoelectric device 200 according to the first exemplary embodiment of the present invention can maximize the heat absorption efficiency of the heat absorption layer 220 due to the anti-reflection layer 250a, and has excellent thermoelectric efficiency because the first reflection layer 260a and the insulating layer 250b can prevent external radiant heat from being absorbed by the heat dissipation layer 240.

<Second exemplary embodiment>

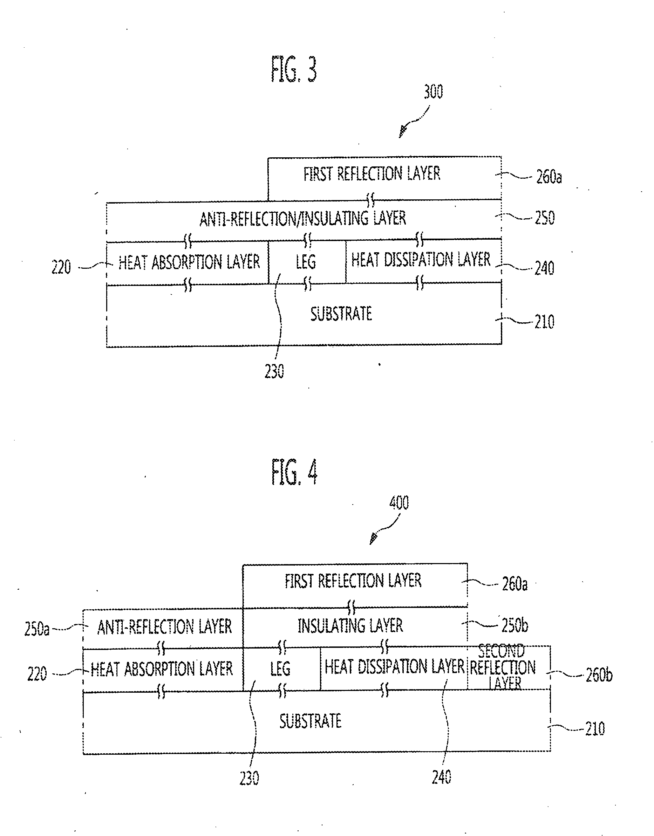

FIG. 3 is a cross-sectional block diagram of a thermoelectric device according to a second exemplary embodiment of the present invention.

Referring to FIG. 3, a thermoelectric device 300 according to the second exemplary embodiment of the present invention includes the same components as the thermoelectric device 200 shown in FIG. 2 except that the anti-reflection layer 250a and the insulating layer 250b are replaced by one anti-reflection/insulating layer 250 to simplify its fabrication process.

Here, the anti-reflection/insulating layer 250 must have a refractive index that is lower than those of the heat absorption layer 220 and the first reflection layer 260a.

<Third exemplary embodiment>

FIG. 4 is a cross-sectional block diagram of a thermoelectric device according to a third exemplary embodiment of the present invention.

Referring to FIG. 4, a thermoelectric device 400 according to the third exemplary embodiment of the present invention includes the same components as the thermoelectric device 200 shown in FIG. 2 except that a second reflection layer 260b is formed to be thermally connected with the heat dissipation layer 240.

Here, the second reflection layer 260b is formed to have a higher thermal conductivity (e.g., 10 W/mK or more) than the heat dissipation layer 240, and dissipates as much heat transferred to the heat dissipation layer 240 as possible away from the heat dissipation layer 240. Also, the second reflection layer 260b functions as a metal interconnection.

Here, the second reflection layer 260b is formed of at least one of Al, Cu, Ti, Ag, Au, W, Si, Pt, Ni, Mo, Ta, Ir, Ru, Zn, Sn and In.

Since the thermoelectric device 400 according to the third exemplary embodiment of the present invention can dissipate as much heat transferred to the heat dissipation layer 240 as possible away from the heat dissipation layer due to the second reflection layer 260b, it can maximize the heat dissipation efficiency of the heat dissipation layer 240 and does not require an additional metal interconnection for connection with an external circuit.

A method of fabricating a thermoelectric device according to an exemplary embodiment of the present invention will be described below.

FIGS, 5A to 5E are cross-sectional block diagrams illustrating a method of fabricating a thermoelectric device according to an exemplary embodiment of the present invention.

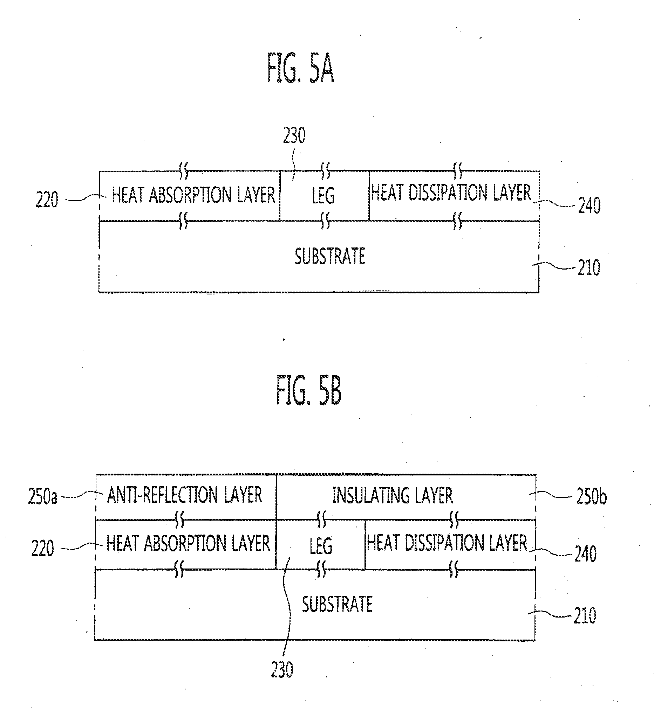

In the first step, as illustrated in FIG. 5A, a heat absorption layer 220, a leg 230, and a heat dissipation layer 240 are formed on a substrate 210.

In the second step, as illustrated in FIG. 5B, an anti-reflection layer 250a is formed on the heat absorption layer 220, and an insulating layer 250b is formed on the leg 230 and the heat dissipation layer 240.

Here, each of the anti-reflection layer 250a and the insulating layer 250b is formed of single dielectric layers formed by depositing one of a low dielectric material (e.g., an oxide or nitride such as Al₂O₃, SiO₂ or SiN) having a low dielectric constant of less than 10, a high dielectric material (e.g., an oxide such as TiO₂, ZrO₂, HfO₂, Ta₂O₅ or ZnO) having a high dielectric constant of 10 or more, and a compound of the low dielectric material and the high dielectric material, or multiple dielectric layers formed by successively depositing the low dielectric material and the high dielectric material. And, the anti-reflection layer 250a and the insulating layer 250b may be formed by atomic layer deposition, plasma atomic layer deposition, sputtering, chemical vapor deposition (CVD), thermal oxidation, etc., or formed by the sol-gel method, spin coating, etc., for mass production.

When the anti-reflection layer 250a is formed by atomic layer deposition, the refractive index of the anti-reflection layer 250a may be adjusted to change reflectance during the deposition process, which will be described in detail below.

For example, when the anti-reflection layer 250a of AlTiO (ATO) is formed by atomic layer deposition using Al₂O₃ having a relatively low refractive index of 1.6 to 1.7 and TiO₂ having a relatively high refractive index of 2.4 to 2.5, the composition of Ti in the anti-reflection layer 250a of ATO is changed by adjusting a cycle ratio of atomic layer deposition. The change in composition leads to a change in the refractive index of the anti-reflection layer 250a of ATO, resulting in a change in reflectance.

Thus, when the refractive index of the anti-reflection layer 250a is adjusted to be lower than that of the heat absorption layer 220 while the anti-reflection layer 250a is formed by atomic layer deposition, radiant light is not reflected by the anti-reflection layer 250a but is absorbed by the heat absorption layer 220 so that radiant heat absorption efficiency can be improved.

In particular, when the refractive index of the anti-reflection layer 250a is adjusted to have a reflectance of 0 to 0.5 at a wavelength of radiant light to be absorbed, the radiant heat absorption efficiency of the heat absorption layer 220 can be maximized.

When the anti-retlection layer 250a is formed of multiple dielectric layers, a dielectric layer having the lowest refractive index among the multiple dielectric layers may be formed in the uppermost layer, and dielectric layers may be formed in lower layers in order of increasing refractive indices. Then, it is possible to further increase the radiant heat absorption efficiency. Here, the refractive indices of all the dielectric layers must be lower than the refractive index of the heat absorption layer 220.

Likewise, when the insulating layer 250b is formed by atomic layer deposition, the refractive index of the insulating layer 250b may be adjusted to be lower than that of the first reflection layer 260a to be formed on the insulating layer 250b during the deposition process, Then, the insulating layer 250b that has a lower refractive index than the first reflection layer 260a can prevent external radiant heat from being absorbed by the heat dissipation layer 240.

When the insulating layer 250b is formed of multiple dielectric layers, a dielectric layer having the lowest refractive index among the multiple dielectric layers may be formed in the uppermost layer, which is in contact with the first reflection layer 260a, and dielectric layers may be formed in lower layers in order of increasing refractive indices. Then, it is possible to further increase the radiant light reflection efficiency. Here, the refractive indices of all the dielectric layers must be lower than the refractive index of the first reflection layer 260a.

Since a dielectric layer can be formed at a relatively low temperature of about 100 to 300 °C by the atomic layer deposition technique used in this exemplary embodiment, the anti-reflection layer 250a and the insulating layer 250b may be formed on a silicon substrate, a glass substrate, a metal substrate, a SOI substrate, or a multilayer substrate in which these substrates are combined. Also, the anti-reflection layer 250a and the insulating layer 250b may be formed on a plastic substrate requiring a process temperature of 150 °C or less. Furthermore, using the atomic layer deposition technique, several dielectric materials can be successively deposited in a vacuum according to a previously-programmed process without stopping the process, similarly to when one material is deposited.

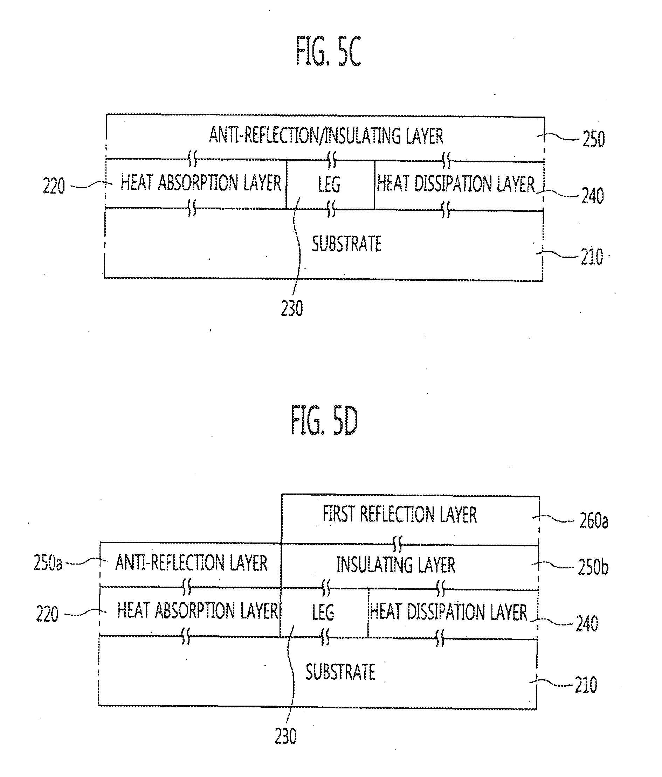

Meanwhile, in the second step, as illustrated in FIG. 5C, the anti-reflection layer 250a and the insulating layer 250b may be simultaneously formed to simplify the fabrication process. In this case, one anti-reflection/insulating layer 250 is formed on the heat absorption layer 220, the leg 230, and the heat dissipation layer 240.

Subsequently, in the third step, as illustrated in FIG. 5D, a first reflection layer 260a that totally rejects external radiant light is formed on the insulating layer 250b. At this time, the first reflection layer 260a is formed of at least one of Al, Cu, Ti, Ag, Au, W, Si, Pt, Ni, Mo, Ta, Ir, Ru, Zn, Sn and In.

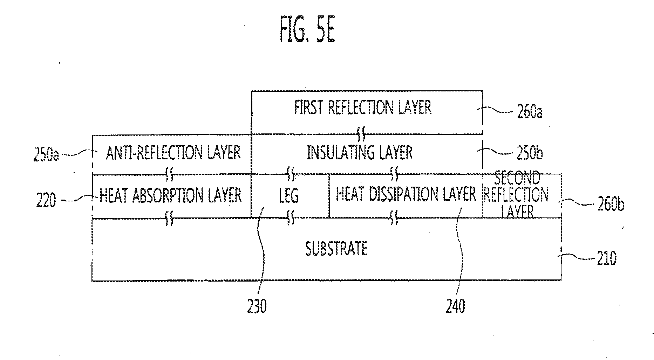

Here, as illustrated in FIG. 5E, a second reflection layer 260b that is thermally connected with the heat dissipation layer 240 and has a higher thermal conductivity (e.g., 10 W/mK or more) than the heat dissipation layer 240 may be formed to improve the heat dissipation efficiency of the heat dissipation layer 240.

The second reflection layer 260b is formed of at least one of Al, Cu, Ti, Ag, Au, W, Si, Pt, Ni, Mo, Ta, Ir, Ru, Zn, Sn and In.

In this case, the second reflection layer 260b dissipates as much heat transferred to the heat dissipation layer 240 as possible away from the heat dissipation layer 240, and also functions as a metal interconnection.

According to an exemplary embodiment of the present invention, it is possible to implement a high-efficiency thermoelectric device that uses radiant heat as a heat source and can maximize the heat absorption efficiency of a heat absorption layer and the heat dissipation efficiency of a heat dissipation layer.

While the invention has been shown and described with reference to certain exemplary embodiments thereof, it will be understood by those skilled in the art that various changes in form and details may be made therein without departing from the spirit and scope of the invention as defined by the appended claims.
In summary an embodiment can be described as follows:
Provided are a thermoelectric device using radiant heat as a heat source and a method of fabricating the same. In the thermoelectric device, an anti-reflection layer formed on a heat absorption layer causes as much radiant light as possible to be absorbed by the heat absorption layer without being reflected to the outside so that the radiant heat absorption efficiency can be improved. Also, in the thermoelectric device, an insulating layer formed on a heat dissipation layer and a first reflection layer formed on the insulating layer can prevent external radiant heat from being absorbed by the heat dissipation layer, and as much radiant heat transferred to the heat dissipation layer as possible can be dissipated away from the heat dissipation layer by a second reflection layer thermally connected with the heat dissipation layer so that the radiant heat emission efficiency can be improved.

## Claims

1. A thermoelectric device using radiant heat as a heat source, comprising:
a substrate;
a heat absorption layer formed on the substrate and absorbing radiant heat;
a leg for transferring the heat absorbed by the heat absorption layer to a heat dissipation layer;
the heat dissipation layer for dissipating the heat transferred from the leg away from the heat dissipation layer;
an anti-reflection layer formed on the heat absorption layer and having a lower refractive index than the heat absorption layer;
an insulating layer formed on the leg and the heat dissipation layer and having a lower refractive index than a first reflection layer; and
the first reflection layer formed on the insulating layer and totally reflecting the radiant light,
wherein the radiant light is not reflected to the outside due to the anti-reflection layer but is absorbed by the heat absorption layer, and the radiant light is not absorbed by the heat dissipation layer but is totally reflected by the insulating layer and the first reflection layer.

2. The thermoelectric device of claim 1, wherein the heat absorption layer and the heat dissipation layer include at least one of group IV elements of the periodic table, Si, Ge, C, Sn and Pb, at least one of group V elements of the periodic table, Sb, As, Bi, P and N, or at least one of group VI elements of the periodic table, Te, Se, Po, S and O.

3. The thermoelectric device of any of the preceding claims, wherein the anti-rejection layer is formed of a single dielectric layer or multiple dielectric layers having a lower retractive index than the heat absorption layer,

4. The thermoelectric device of claim 3, wherein when the anti-reflection layer is formed of multiple dielectric layers, a dielectric layer having the lowest refractive index is formed in the uppermost layer, and dielectric layers are formed in lower layers in order of increasing refractive indices.

5. The thermoelectric device of any of the preceding claims, wherein the insulating layer is formed of a single dielectric layer or multiple dielectric layers having a lower refractive index than the first reflection layer.

6. The thermoelectric device of claim 5, wherein when the insulating layer is formed of multiple dielectric layers, a dielectric layer haying the lowest refractive index is formed in the uppermost layer, and dielectric layers are formed in lower layers in order of increasing refractive indices.

7. The thermoelectric device of any preceding claims, further comprising a second reflection layer formed to be thermally connected with the heat dissipation layer and have a higher thermal conductivity than the heat dissipation layer, and dissipating the heat transferred to the heat dissipation layer away from the heat dissipation layer.

8. A method of fabricating a thermoelectric device using radiant heat as a heat source, the method comprising:
forming, on a substrate, a heat absorption layer absorbing radiant heat, a leg transferring the heat absorbed by the heat absorption layer to a heat dissipation layer, and the heat dissipation layer dissipating the heat transferred from the leg away from the heat dissipation layer;
forming an anti-reflection layer having a lower refractive index than the heat absorption layer on the heat absorption layer, and an insulating layer having a lower refractive index than a first reflection layer to be formed later on the heat dissipation layer; and
forming the first reflection layer totally reflecting radiant light on the insulating layer.

9. The method of claim 8, wherein forming the anti-reflection layer and the insulating layer includes forming each of the anti-reflection layer and the insulating layer to have a single dielectric layer or multiple dielectric layers by one of atomic layer deposition, chemical vapor deposition (CVD), and sputtering.

10. The method of claim 9, wherein forming the anti-reflection layer and the insulating layer further includes adjusting the refractive index of the anti-reflection layer to be lower than that of the heat absorption layer while the anti-reflection layer is formed.

11. The method of claim 10, wherein forming the anti-reflection layer and the insulating layer further includes, when the anti-reflection layer is formed of multiple dielectric layers, forming a dielectric layer having the lowest refractive index in the uppermost layer and dielectric layers in lower layers in order of increasing refractive indices.

12. The method or any of claims 9 to 11, wherein forming the anti-reflection layer and the insulating layer further includes adjusting the refractive index of the insulating layer to be lower than that of the first reflection layer while the insulating layer is formed.

13. The method of claim 12, wherein forming the anti-reflection layer and the insulating layer further includes, when the insulating layer is formed of multiple dielectric layers, forming a dielectric layer having the lowest refractive index in the uppermost layer and dielectric layers in lower layers in order of increasing refractive indices.

14. The method of any of claims 8 to 13, wherein forming the anti-reflection layer and the insulating layer includes simultaneously forming the anti-reflection layer and the insulating layer to have a single dielectric layer or multiple dielectric layers by one of atomic layer deposition, chemical vapor deposition (CVD), and sputtering.

15. The method of claim 8, wherein forming the first reflection layer includes forming a second reflection layer thermally connected witch the heal dissipation layer and having a higher thermal conductivity than the heat dissipation layer.

## Patentansprüche

1. Thermoelektrische Vorrichtung, die Strahlungswärme als Wärmequelle verwendet, umfassend:
ein Substrat;
eine Wärmeabsorptionsschicht, die auf dem Substrat gebildet ist und Strahlungswärme absorbiert;
ein Bein zum Übertragen der durch die Wärmeabsorptionsschicht absorbierten Wärme an eine Wärmeabgabeschicht;
die Wärmeabgabeschicht zum Abgeben der von dem Bein übertragenen Wärme weg von der Wärmeabgabeschicht;
eine Antireflexionsschicht, die auf der Wärmeabsorptionsschicht gebildet ist und die einen kleineren Brechungsindex aufweist als die Wärmeabsorptionsschicht;
eine Isolierschicht, die auf dem Bein und der Wärmeabgabeschicht gebildet ist, und die einen kleineren Brechungsindex als eine erste Reflexionsschicht hat; und
die erste Reflexionsschicht, die auf der Isolierschicht gebildet ist und das Strahlungslicht total reflektiert,
wobei das Strahlungslicht aufgrund der Antireflexionsschicht nicht nach außen reflektiert wird, sondern durch die Wärmeabsorptionsschicht absorbiert wird, und wobei das Strahlungslicht nicht durch die Wärmeabgabeschicht absorbiert wird, sondern durch die Isolierschicht und die erste Reflexionsschicht total reflektiert wird.

2. Thermoelektrische Vorrichtung nach Anspruch 1, wobei die Wärmeabsorptionsschicht und die Wärmeabgabeschicht wenigstens eines der Gruppe IV Elemente des Periodensystems, Si, Ge, C, Sn und Pb enthalten, wenigstens eines der Gruppe V Elemente des Periodensystems Sb, As, Bi, P und N, oder wenigstens eines der Gruppe VI Elemente des Periodensystems Te, Se, Po, S und O.

3. Thermoelektrische Vorrichtung nach einem der vorhergehenden Ansprüche, wobei die Antireflexionsschicht aus einer einzigen dielektrischen Schicht oder mehreren dielektrischen Schichten mit einem kleineren Brechungsindex als die Wärmeabsorptionsschicht gebildet ist.

4. Thermoelektrische Vorrichtung nach Anspruch 3, wobei dann, wenn die Antireflexionsschicht aus mehreren dielektrischen Schichten gebildet ist, eine dielektrische Schicht mit dem kleinsten Brechungsindex in der obersten Schicht gebildet ist, und dielektrische Schichten in tieferen Schichten in einer Reihenfolge mit zunehmenden Brechungsindizes gebildet sind.

5. Thermoelektrische Vorrichtung nach einem der vorhergehenden Ansprüche, wobei die Isolierschicht aus einer einzigen dielektrischen Schicht oder mehreren dielektrischen Schichten mit einem kleineren Brechungsindex als die erste Reflexionsschicht gebildet ist.

6. Thermoelektrische Vorrichtung nach Anspruch 5, wobei dann, wenn die Isolierschicht aus mehreren dielektrischen Schichten gebildet ist, eine dielektrische Schicht mit dem kleinsten Brechungsindex in der obersten Schicht gebildet ist, und dielektrische Schichten in tieferen Schichten in einer Reihenfolge mit zunehmenden Brechungsindizes gebildet sind.

7. Thermoelektrische Vorrichtung nach einem der vorhergehenden Ansprüche, ferner umfassend eine zweite Reflexionsschicht, die derart gebildet ist, dass sie thermisch mit der Wärmeabgabeschicht verbunden ist und eine größere thermische Leitfähigkeit aufweist als die Wärmeabgabeschicht, und die die zur Wärmeabgabeschicht übertragene Wärme von der Wärmeabgabeschicht weg abgibt.

8. Verfahren zur Herstellung einer thermoelektrischen Vorrichtung, die Strahlungswärme als eine Wärmequelle verwendet, wobei das Verfahren umfasst:
Bilden, auf einem Substrat, einer Wärmeabsorptionsschicht, die Strahlungswärme absorbiert, eines Beins, das die durch die Wärmeabsorptionsschicht absorbierte Wärme zu einer Wärmeabgabeschicht überträgt, und der Wärmeabgabeschicht, die die von dem Bein übertragene Wärme von der Wärmeabgabeschicht weg abgibt;
Bilden einer Antireflexionsschicht mit einem kleineren Brechungsindex als die Wärmeabsorptionsschicht auf der Wärmeabsorptionsschicht, sowie einer Isolierschicht mit einem kleineren Brechungsindex als eine erste Reflexionsschicht, die später auf der Wärmeabgabeschicht gebildet werden soll; und
Bilden der ersten Reflexionsschicht, die Strahlungslicht an der Isolierschicht total reflektiert.

9. Verfahren nach Anspruch 8, wobei das Bilden der Antireflexionsschicht und der Isolierschicht ein Bilden sowohl der Antireflexionsschicht als auch der Isolierschicht mit einer einzigen dielektrischen Schicht oder mehreren dielektrischen Schichten mittels Atomschichtabscheidung, chemischer Dampfabscheidung (CVD) oder Sputtern umfasst.

10. Verfahren nach Anspruch 9, wobei das Bilden der Antireflexionsschicht und der Isolierschicht ferner ein Einstellen des Brechungsindex der Antireflexionsschicht derart umfasst, dass er kleiner ist als jener der Wärmeabsorptionsschicht während die Antireflexionsschicht gebildet wird.

11. Verfahren nach Anspruch 10, wobei das Bilden der Antireflexionsschicht und der Isolierschicht ferner, wenn die Antireflexionsschicht aus mehreren dielektrischen Schichten gebildet ist, ein Bilden einer dielektrischen Schicht mit dem kleinsten Brechungsindex in der obersten Schicht und von dielektrischen Schichten in tieferen Schichten in einer Reihenfolge mit zunehmenden Brechungsindizes umfasst.

12. Verfahren nach einem der Ansprüche 9 bis 11, wobei das Bilden der Antireflexionsschicht und der Isolierschicht ferner ein Einstellen des Brechungsindex der Isolierschicht derart umfasst, dass er kleiner ist als jener der ersten Reflexionsschicht, während die Isolierschicht gebildet wird.

13. Verfahren nach Anspruch 12, wobei das Bilden der Antireflexionsschicht und der Isolierschicht ferner, wenn die Isolierschicht aus mehreren dielektrischen Schichten gebildet ist, ein Bilden einer dielektrischen Schicht mit dem kleinsten Brechungsindex in der obersten Schicht und von dielektrischen Schichten in tieferen Schichten in einer Reihenfolge mit zunehmenden Brechungsindizes umfasst.

14. Verfahren nach einem der Ansprüche 8 bis 13, wobei das Bilden der Antireflexionsschicht und der Isolierschicht ein gleichzeitiges Bilden der Antireflexionsschicht und der Isolierschicht mit einer einzigen dielektrischen Schicht oder mehreren dielektrischen Schichten mittels Atomschichtenabscheidung, chemischer Dampfabscheidung (CVD) oder Sputtern umfasst.

15. Verfahren nach Anspruch 8, wobei das Bilden der ersten Reflexionsschicht ein Bilden einer zweiten Reflexionsschicht umfasst, die thermisch mit der Wärmeabgabeschicht verbunden ist und eine größere thermische Leitfähigkeit als die Wärmeabgabeschicht aufweist.

## Revendications

1. Dispositif thermoélectrique utilisant de la chaleur rayonnante comme source de chaleur, comprenant :
un substrat ;
une couche d'absorption de chaleur formée sur le substrat et absorbant de la chaleur rayonnante ;
une branche destinée à transférer la chaleur absorbée par la couche d'absorption de chaleur vers une couche de dissipation de chaleur ;
la couche de dissipation de chaleur destinée à dissiper la chaleur transférée par la branche en éloignement de la couche de dissipation de chaleur ;
une couche antireflet formée sur la couche d'absorption de chaleur et ayant un indice de réfraction inférieur à celui de la couche d'absorption de chaleur ;
une couche isolante formée sur la branche et la couche de dissipation de chaleur et ayant un indice de réfraction inférieur à celui d'une première couche de réflexion ; et
la première couche de réflexion formée sur la couche isolante et réfléchissant totalement la lumière rayonnante,
dans lequel la lumière rayonnante n'est pas réfléchie vers l'extérieur en raison de la couche antireflet mais est absorbée par la couche d'absorption de chaleur, et la lumière rayonnante n'est pas absorbée par la couche de dissipation de chaleur mais est totalement réfléchie par la couche isolante et la première couche de réflexion.

2. Dispositif thermoélectrique selon la revendication 1, dans lequel la couche d'absorption de chaleur et la couche de dissipation de chaleur incluent au moins l'un des éléments du groupe IV du tableau périodique, Si, Ge, C, Sn et Pb, au moins l'un des éléments du groupe V du tableau périodique, Sb, As, Bi, P et N, ou au moins l'un des éléments du groupe VI du tableau périodique, Te, Se, Po, S et O.

3. Dispositif thermoélectrique selon l'une quelconque des revendications précédentes, dans lequel la couche antireflet est formée d'une couche diélectrique unique ou de multiples couches diélectriques ayant un indice de réfraction inférieur à celui de la couche d'absorption de chaleur.

4. Dispositif thermoélectrique selon la revendication 3, dans lequel lorsque la couche antireflet est formée de multiples couches diélectriques, une couche diélectrique ayant l'indice de réfraction le plus bas est formée dans la couche la plus élevée, et des couches diélectriques sont formées dans des couches inférieures afin d'augmenter les indices de réfraction.

5. Dispositif thermoélectrique selon l'une quelconque des revendications précédentes, dans lequel la couche isolante est formée d'une couche diélectrique unique ou de multiples couches diélectriques ayant un indice de réfraction inférieur à celui de la première couche de réflexion.

6. Dispositif thermoélectrique selon la revendication 5, dans lequel lorsque la couche isolante est formée de multiples couches diélectriques, une couche diélectrique ayant l'indice de réfraction le plus bas est formée dans la couche la plus élevée, et des couches diélectriques sont formées dans des couches inférieures afin d'augmenter les indices de réfraction.

7. Dispositif thermoélectrique selon l'une quelconque des revendications précédentes, comprenant en outre une seconde couche de réflexion formée pour être reliée thermiquement à la couche de dissipation de chaleur et avoir une conductivité thermique supérieure à celle de la couche de dissipation de chaleur, et dissipant la chaleur transférée vers la couche de dissipation de chaleur en éloignement de la couche de dissipation de chaleur.

8. Procédé de fabrication d'un dispositif thermoélectrique utilisant de la chaleur rayonnante comme source de chaleur, le procédé comprenant :
la formation, sur un substrat, d'une couche d'absorption de chaleur absorbant de la chaleur rayonnante, une branche transférant la chaleur absorbée par la couche d'absorption de chaleur vers une couche de dissipation de chaleur, et la couche de dissipation de chaleur dissipant la chaleur transférée par la branche en éloignement de la couche de dissipation de chaleur ;
la formation d'une couche antireflet ayant un indice de réfraction inférieur à celui de la couche d'absorption de chaleur sur la couche d'absorption de chaleur, et une couche isolante ayant un indice de réfraction inférieur à celui d'une première couche de réflexion devant être formée plus tard sur la couche de dissipation de chaleur ; et
la formation de la première couche de réflexion réfléchissant totalement la lumière rayonnante sur la couche isolante.

9. Procédé selon la revendication 8, dans lequel la formation de la couche antireflet et de la couche isolante inclut la formation de chacune de la couche antireflet et la couche isolante afin d'avoir une couche diélectrique unique ou de multiples couches diélectriques par l'un du dépôt par couche atomique, du dépôt chimique en phase vapeur (CVD) et de la pulvérisation cathodique.

10. Procédé selon la revendication 9, dans lequel la formation de la couche antireflet et de la couche isolante inclut en outre le réglage de l'indice de réfraction de la couche antireflet afin qu'il soit inférieur à celui de la couche d'absorption de chaleur pendant la formation de la couche antireflet.

11. Procédé selon la revendication 10, dans lequel la formation de la couche antireflet et de la couche isolante inclut en outre, lorsque la couche antireflet est formée de multiples couches diélectriques, la formation d'une couche diélectrique ayant l'indice de réfraction le plus bas dans la couche la plus élevée et de couches diélectriques dans les couches inférieures afin d'augmenter les indices de réfraction.

12. Procédé selon l'une quelconque des revendications 9 à 11, dans lequel la formation de la couche antireflet et de la couche isolante comprend en outre le réglage de l'indice de réfraction de la couche isolante afin qu'il soit inférieur à celui de la première couche de réflexion pendant la formation de la couche isolante.

13. Procédé selon la revendication 12, dans lequel la formation de la couche antireflet et de la couche isolante comprend en outre, lorsque la couche isolante est formée de multiples couches diélectriques, la formation d'une couche diélectrique ayant l'indice de réfraction le plus bas dans la couche la plus élevée et de couches diélectriques dans des couches inférieures afin d'augmenter les indices de réfraction.

14. Procédé selon l'une quelconque des revendications 8 à 13, dans lequel la formation de la couche antireflet et de la couche isolante inclut la formation simultanée de la couche antireflet et de la couche isolante afin d'avoir une couche diélectrique unique ou de multiples couches diélectriques par l'un du dépôt par couche atomique, du dépôt chimique en phase vapeur (CVD) et de la pulvérisation cathodique.

15. Procédé selon la revendication 8, dans lequel la formation de la première couche de réflexion inclut la formation d'une seconde couche de réflexion reliée thermiquement à la couche de dissipation de chaleur et ayant une conductivité thermique supérieure à celle de la couche de dissipation de chaleur.
